(19) Europäisches Patentamt
European Patent Office
Office européen des brevets

(11) **EP 1 865 544 A1**

(12) **EUROPEAN PATENT APPLICATION**
published in accordance with Art. 158(3) EPC

(43) Date of publication:
**12.12.2007 Bulletin 2007/50**

(51) Int Cl.:
*H01L 21/265* (2006.01)     *H01L 21/22* (2006.01)

(21) Application number: **06730669.6**

(22) Date of filing: **30.03.2006**

(86) International application number:
**PCT/JP2006/306721**

(87) International publication number:
**WO 2006/106858 (12.10.2006 Gazette 2006/41)**

(84) Designated Contracting States:
**DE FR GB**

(30) Priority: **31.03.2005 JP 2005104160**

(71) Applicant: **MATSUSHITA ELECTRIC INDUSTRIAL CO., LTD.**
**Osaka 571-8501 (JP)**

(72) Inventors:
• **SASAKI, Yuichiro**
**c/o Ultimate Junction Technologies Inc.,**
**Osaka 570-8501 (JP)**
• **OKUMURA, Tomohiro**
**c/o Matsushita Electric Industrial Co., Ltd.,**
**Chuo-ku, Osaka-shi, Osaka 540-6207 (JP)**

• **OKASHITA, Katsumi**
**c/o Ultimate Junction Technologies Inc.,**
**Osaka 570-8501 (JP)**
• **ITO, Hiroyuki**
**c/o Ultimate Junction Technologies Inc.,**
**Osaka 570-8501 (JP)**
• **MIZUNO, Bunji**
**c/o Ultimate Junction Technologies Inc.,**
**Osaka 570-8501 (JP)**

(74) Representative: **Grünecker, Kinkeldey,**
**Stockmair & Schwanhäusser**
**Anwaltssozietät**
**Maximilianstraße 58**
**D-80538 München (DE)**

(54) **PLASMA DOPING METHOD AND APPARATUS**

(57)     There are provided a plasma doping method and apparatus which is excellent in a repeatability and a controllability of an implanting depth of an impurity to be introduced into a sample or a depth of an amorphous layer.

A plasma doping method of generating a plasma in a vacuum chamber and colliding an ion in the plasma with a surface of a sample to modify a surface of a crystal sample to be amorphous, includes the steps of carrying out a plasma irradiation over a dummy sample to perform an amorphizing treatment together with a predetermined number of samples, irradiating a light on a surface of the dummy sample subjected to the plasma irradiation, thereby measuring an optical characteristic of the surface of the dummy sample, and controlling a condition for treating the sample in such a manner that the optical characteristic obtained at the measuring step has a desirable value.

*FIG. 1*

**EP 1 865 544 A1**

## Description

<TECHNICAL FIELD>

The present invention relates to a plasma doping method and apparatus for implanting an ion into a surface of a sample to be a crystal by using a plasma.

<BACKGROUND ART>

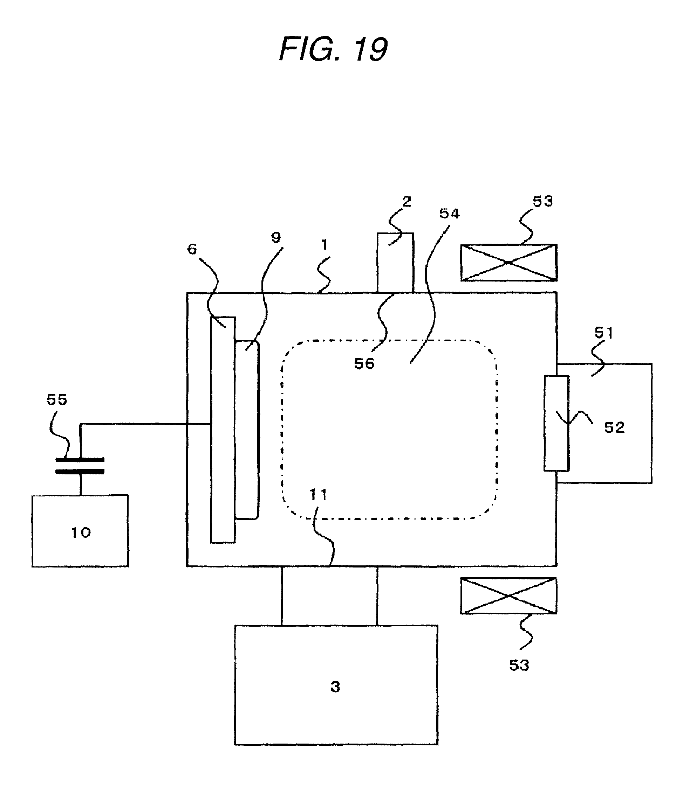

As a technique for irradiating a plasma to modify a surface of a sample to be a crystal into an amorphous state, a plasma doping method using a plasma of helium has been disclosed (see Non-Patent Document 1). Fig. 19 shows a schematic structure of a typical plasma treating apparatus to be used for plasma doping according to the conventional art. In Fig. 19, a sample electrode 6 for mounting a sample 9 formed by a silicon substrate is provided in a vacuum chamber 1. There are provided a gas supplying device 2 for supplying a source gas containing a desirable element, for example, a helium gas into the vacuum chamber 1 and a pump 3 for reducing a pressure in the vacuum chamber 1, and an inner part of the vacuum chamber 1 can be thus maintained to have a predetermined pressure. A microwave is radiated into the vacuum chamber 1 by a microwave waveguide 51 through a quartz plate 52 to be a dielectric window. By an interaction of the microwave and a DC magnetic field formed by an electromagnet 53, a magnetoactive microwave plasma (an electron cyclotron resonance plasma) 54 is formed in the vacuum chamber 1. A high frequency power supply 10 is connected to the sample electrode 6 through a capacitor 55 so that an electric potential of the sample electrode 6 can be controlled. A gas supplied from the gas supplying device 2 is introduced into the vacuum chamber 1 from a gas introducing port 56 and is discharged from the exhaust port 11 to the pump 3.

In the plasma treating apparatus having the structure, a source gas introduced from the gas introducing port 56, for example, a helium gas is changed into a plasma by plasma generating means formed by the microwave waveguide 51 and the electromagnet 53 and a helium ion in the plasma 54 is introduced into the surface of the sample 9 by means of the high frequency power supply 10.

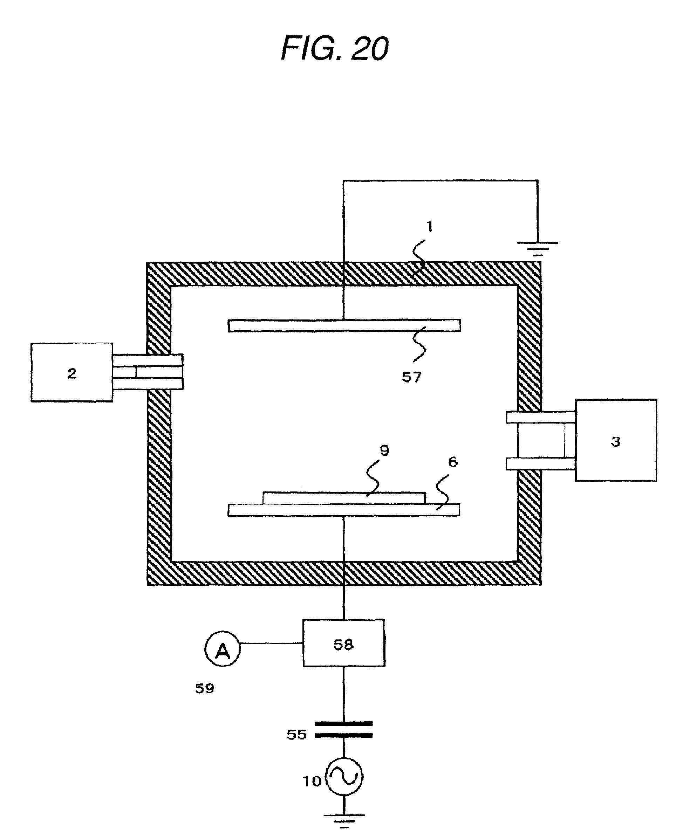

In the plasma doping method and apparatus, a method of measuring a high frequency current to be supplied to a sample electrode has been proposed as a method for controlling a doping amount. Fig. 20 shows a schematic structure of an apparatus according to an example. In Fig. 20, a sample electrode 6 for mounting a sample 9 formed by a silicon substrate is provided in a vacuum chamber 1. There are provided a gas supplying device 2 for supplying a doping gas containing a desirable element, for example, $B_2H_6$ into the vacuum chamber 1 and a pump 3 for reducing a pressure in the vacuum chamber 1, and an inner part of the vacuum chamber 1 can be thus maintained to have a predetermined pressure. A high frequency power is supplied to the sample electrode 6 through a capacitor 55 and a high frequency current transformer 58 by a power supply 10 so that a plasma is formed in the vacuum chamber 1 and a boron ion in the plasma is introduced into a surface of the sample 9. By measuring a high frequency current in a discharge by a voltmeter 59 through the high frequency current transformer 58, it is possible to control a concentration of the boron which is doped. A counter electrode 57 is provided opposite to the sample electrode and is grounded.

A desirable impurity such as boron is introduced into the surface of the sample 9 thus amorphized by means such as an ion implantation or plasma doping to carry out an activating treatment which will be described below. Furthermore, a metal wiring layer is formed on the sample 9 into which the impurity is implanted and a thin oxide film is then formed on the metal wiring layer in a predetermined oxidizing atmosphere, and a gate electrode is thereafter formed on the sample 9 by a CVD apparatus. Consequently, an MOS transistor is obtained, for example. In order to form the transistor, it is necessary to introduce an impurity ion by a plasma doping treatment and to then carry out an activating treatment. The activating treatment implies a treatment for heating a layer having the impurity introduced therein by using a method such as RTA (rapid heating annealing), Spike RTA (spike rapid heating annealing), laser annealing or flash lamp annealing, thereby carrying out a recrystallization.

At this time, it is possible to obtain a shallow activating layer by effectively heating a very thin layer into which an impurity is introduced. In order to effectively heat the very thin layer into which the impurity is introduced, there is carried out a treatment for increasing an absorption ratio to a light irradiated from a light source such as a laser or a lamp in the very thin layer to which an impurity is to be introduced before the introduction of an impure portion. The treatment is referred to as a preamorphization and serves to generate a plasma such as the He gas and to accelerate and collide a generated ion such as He toward a substrate through a bias voltage, and to break a crystal structure of a surface of the substrate, thereby carrying out an amorphization in a plasma treating apparatus having the same structure as the plasma treating apparatus described above, and has already been proposed by the inventors.

Non-Patent Document 1 : Y Sasaki et al., "B2H6 Plasma Doping with In-situ He Pre-amorphyzation", 2004 Symposia on VLSI Technology and Circuits

When the boron is to be implanted into a silicon crystal by an ion implantation, moreover, it is implanted deeply by a channeling effect. The channeling effect is a phenomenon which is widely known, and the boron does not collide with a silicon atom and is implanted deeply to pass through a tunnel in a crystal. Also in the case in which the boron is to be implanted shallowly with a reduction in the effect, a preamorphizing treatment is used. More specifically, a crystal of silicon is brought to be amorphous before the implantation of the boron, and an arrangement of the silicon atom is scattered. Consequently, a boron atom randomly collides with the silicon atom and can be thus implanted shallowly.

Furthermore, it is possible to carry out the introduction of the impurity ion and the amorphization at the same time. Also in this case, there is used a plasma treating apparatus having the same structure as that of the plasma treating apparatus described above. A plasma of a gas in which a very small amount of $B_2H_6$ gas is mixed into the He gas is generated and the generated ion such as He is accelerated and caused to collide toward a substrate through the bias voltage, and a crystal structure of a surface of the substrate is broken to carry out the amorphization, and at the same time, an ion such as B is accelerated toward the substrate through the bias voltage and is implanted into the substrate.

<DISCLOSURE OF THE INVENTION>

<PROBLEMS THAT THE INVENTION IS TO SOLVE>

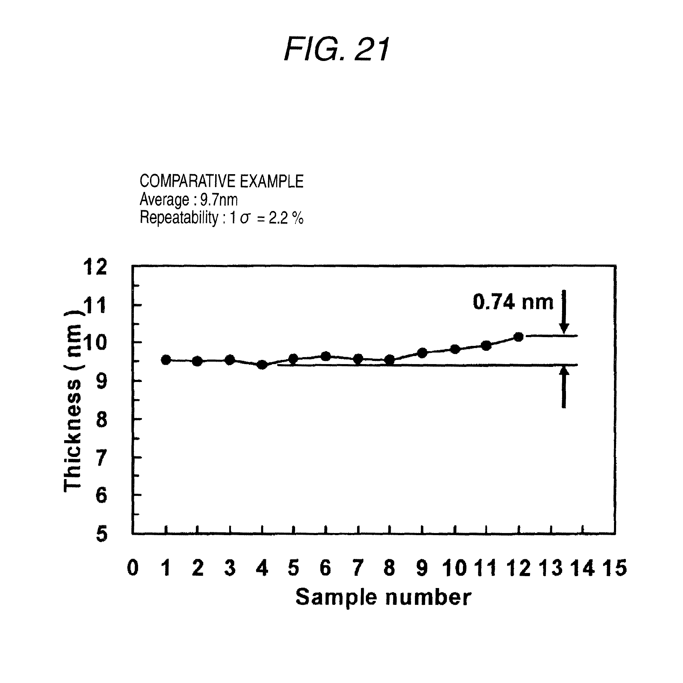

However, the conventional method has a problem in that a repetitive reproducibility is poor. Fig. 21 shows a result obtained by measuring a depth of an amorphous layer formed on a surface of a silicon wafer at this time. An axis of ordinates indicates the depth of the amorphous layer and an axis of abscissas indicates the number of samples. In other words, there is generated a problem in that a variation in the depth of the amorphous layer formed on the surface of the silicon wafer is increased though a plasma doping treatment is carried out on the same condition. A new problem is caused for the first time in the amorphization carried out through a plasma irradiation proposed by the inventors. This is a problem which is not caused in the conventional technique for implanting an ion such as germanium or silicon, for example. The reason is that an acceleration energy of an ion can be obtained with an excellent controllability and repeatability at a voltage to be applied to an accelerating electrode in the ion implantation. Referring to ionic species to be irradiated onto a silicon wafer, moreover, single and desirable ionic species can be obtained with an excellent repeatability by means of an analyzing electromagnet. Furthermore, a dose of the ion is obtained with an excellent repeatability by means of an electrical dose monitor using a Faraday cup and a time control. It has been known that an amorphous layer can easily be formed with an excellent repeatability because the amorphous layer is determined by the ion species, the acceleration energy and the dose.

In the case in which an impurity ion is to be introduced by plasma doping, moreover, there is also a problem in that a repetitive reproducibility of a boron implanting depth is poor. There is generated a drawback in that a variation in the implanting depth of the boron is increased irrespective of the execution of the plasma doping treatment on the same condition. This is a peculiar problem to the plasma doping. Referring to the plasma doping, an ion in a plasma is accelerated with a potential difference made in a plasma sheath between a plasma and a substrate. However, a state of the plasma is less stabilized as compared with a voltage to be applied to an accelerating electrode in the ion implantation and a controllability is also poor. The reason is that the plasma is changed depending on a state of a process chamber and the state of the process chamber is thus varied at each time because a deposited substance containing boron is stuck to the process chamber when the plasma doping is repetitively carried out for a production. When the state of the plasma is changed, the potential difference made in the plasma sheath is also varied. Therefore, the controllability of the impurity implanting depth is deteriorated. This is a drawback which is not caused in the conventional art for implanting a boron ion, for example.

The invention has been made in consideration of the actual circumstances and has an object to provide a plasma doping method and apparatus in which a repeatability and a controllability of a depth of an amorphous layer formed on a surface of a sample and an impurity implanting depth are excellent.

<MEANS FOR SOLVING THE PROBLEMS>

Therefore, the invention provides a plasma doping method for generating a plasma in a vacuum chamber and colliding an ion in the plasma with a surface of a sample to modify a surface of a crystal sample to be amorphous, comprising the steps of carrying out a plasma irradiation over a dummy sample to perform an amorphizing treatment together with a predetermined number of samples, irradiating a light on a surface of the dummy sample subjected to the plasma irradiation, thereby measuring an optical characteristic of the surface of the dummy sample, and controlling a condition for treating the sample in such a manner that the optical characteristic obtained at the measuring step has a desirable value.

The invention proposes a method of controlling an implanting depth of an impurity ion by the plasma doping, thereby improving a repeatability. In other words, when the impurity ion is to be implanted by the plasma doping, an amorphization is carried out simultaneously with or prior to the implantation. At this time, the inventors newly found that the implanting depth of the impurity ion and the depth of the amorphous layer have a great proportional relationship in the case in which the a silicon crystal is brought to be amorphous simultaneously with the implantation of the impurity ion through the plasma doping. They found that it is also possible to control the implanting depth of the impurity ion by controlling the depth of the amorphous layer through a method of measuring the depth of the amorphous layer by using a light to set a plasma doping condition in such a manner that a measured value is equal to a desirable value.

The invention is characterized in that the depth of the amorphous layer is measured by using the light and a plasma doping condition is set in such a manner that the measured value is equal to the desirable value in the plasma doping to improve a repetitive reproducibility of the depth of the amorphous layer, and furthermore, the repetitive reproducibility of the implanting depth of the impurity ion is enhanced by utilizing the fact that the implanting depth of the impurity ion and the depth of the amorphous layer have a great proportional relationship in the plasma doping.

In the method according to the invention, moreover, the step of performing an amorphizing treatment serves to mount a sample on a sample electrode in the vacuum chamber and to accelerate and collide the ion in the plasma toward a surface of the sample to modify the surface of the sample to be a crystal into an amorphous state while generating a plasma in the vacuum chamber.

In the method according to the invention, furthermore, the step of performing an amorphizing treatment serves to mount a sample on a sample electrode in the vacuum chamber and to exhaust an inner part of the vacuum chamber while supplying a gas into the vacuum chamber by a gas supplying device, to generate a plasma in the vacuum chamber by supplying a power to the sample electrode while controlling the inner part of the vacuum chamber to have a predetermined pressure, and to accelerate and collide an ion in the plasma toward a surface of the sample, thereby modifying the surface of the sample to be a crystal into an amorphous state.

In addition, in the method according to the invention, the step of performing an amorphizing treatment serves to mount a sample on a sample electrode in the vacuum chamber and to exhaust an inner part of the vacuum chamber while supplying a gas into the vacuum chamber by a gas supplying device, to generate a plasma in the vacuum chamber by supplying a high frequency power to a plasma source while controlling the inner part of the vacuum chamber to have a predetermined pressure, and to accelerate and collide an ion in the plasma toward a surface of the sample by supplying a power to the sample electrode.

In the invention according to the invention, moreover, the measuring step serves to control treating conditions of a step of irradiating a light on the surface of the dummy sample subjected to a plasma doping treatment, thereby detecting a difference in a polarizing state between an incident light and a reflected light and calculating a depth of an amorphous layer based on the optical characteristic of the surface of the dummy sample from the difference, and the step of carrying out a modification in such a manner that the depth of the amorphous layer thus calculated has a predetermined value.

In the method according to the invention, furthermore, the modifying step includes a step of controlling the treating conditions in order to change an acceleration energy for accelerating the ion in the plasma toward the surface of the sample.

In addition, in the method according to the invention, the modifying step includes a step of controlling the treating conditions in order to change a potential difference which can be regulated with a magnitude of a power formed between the plasma and the sample electrode by varying a power to be supplied to the sample electrode.

In the method according to the invention, moreover, the modifying step includes a step of controlling the treating conditions in order to change a time required for irradiating a plasma.

In the method according to the invention, furthermore, the modifying step includes a step of controlling the treating conditions in order to change a high frequency power to be supplied to a plasma source.

In addition, in the method according to the invention, the modifying step includes a step of controlling the treating conditions in order to change a pressure in the vacuum chamber.

In the method according to the invention, moreover, the sample is a semiconductor substrate formed of silicon.

In the method according to the invention, furthermore, the plasma to be generated in the vacuum chamber is constituted by an inert gas.

In addition, in the method according to the invention, the plasma to be generated in the vacuum chamber is constituted by helium or neon.

In the method according to the invention, moreover, the plasma to be generated in the vacuum chamber contains an impurity and serves to carry out plasma doping for modifying the surface of the sample to be a crystal into an amorphous state, and at the same time, introducing the impurity into the surface of the sample.

In the method according to the invention, furthermore, the impurity is boron.

In addition, in the method according to the invention, the plasma contains boron diluted with helium.

In the method according to the invention, moreover, the plasma to be generated in the vacuum chamber contains diboron.

In the method according to the invention, furthermore, the plasma to be generated in the vacuum chamber contains arsenic, phosphorus or antimony, and a substance for carrying out plasma doping to modify the surface of the sample to be a crystal into an amorphous state, and at the same time, to introduce the arsenic, the phosphorus or the antimony into the surface of the sample.

In addition, in the method according to the invention, the dummy sample is a part of a sample provided in an unnecessary portion for a device of the sample.

Moreover, the invention provides a plasma doping method of generating a plasma in a vacuum chamber and colliding an ion in the plasma with a surface of a sample to modify a surface of a crystal sample to be amorphous, comprising the steps of carrying out a plasma irradiation over a dummy sample to perform an amorphizing treatment together with a predetermined number of samples, measuring a depth of an amorphous layer formed on a surface of the dummy sample subjected to the plasma irradiation, and controlling a condition for treating the crystal sample in such a manner that the depth of the amorphous layer obtained at the measuring step has a desirable value.

In the method according to the invention, furthermore, the depth of the amorphous layer is controlled to control a depth of an impurity ion which is introduced.

In addition, the invention provides an apparatus comprising a vacuum chamber, a sample electrode, a plasma doping chamber including plasma supplying means for supplying a plasma to the sample and a power supply for the sample electrode which serves to supply a power to the sample electrode, a light irradiating portion for irradiating a light on the sample, and a detecting portion for detecting polarizing states of an incident light on the sample and a reflected light.

In the apparatus according to the invention, moreover, the plasma doping chamber is provided with gas supplying means for supplying a gas into the vacuum chamber, exhausting means for exhausting an inner part of the vacuum chamber, and pressure control means for controlling a pressure in the vacuum chamber.

In the apparatus according to the invention, furthermore, the detecting portion is provided in the plasma doping chamber.

In addition, in the apparatus according to the invention, the detecting portion is provided in an inspecting chamber provided separately from the plasma doping chamber.

In the invention, it is assumed that the optical characteristic indicates a result of an optical measurement which is caused by a depth of an amorphous layer formed by a modification or a difference in a degree of an amorphousness depending on a degree of the modification.

BRIEF DESCRIPTION OF THE DRAWINGS

Fig. 1 is a sectional view showing a structure of a plasma doping chamber used in a first embodiment according to the invention.
Fig. 2 is a plan view showing a whole structure of a plasma doping apparatus according to the first embodiment of the invention.
Fig. 3 is a sectional view showing a structure of a heating chamber of a lamp annealing type according to the first embodiment of the invention.
Fig. 4 is a sectional view showing a structure of a heating chamber of a laser annealing type according to the first embodiment of the invention.
Fig. 5 is a perspective view showing a schematic structure of a sheet resistance measuring device according to the first embodiment of the invention.
Fig. 6 is a plan view showing a silicon substrate according to a second embodiment of the invention.
Fig. 7 is a sectional view showing a structure of a heating chamber of a lamp annealing type according to the second embodiment of the invention.
Fig. 8 is a plan view showing a whole structure of a plasma doping apparatus according to a third embodiment of the invention.
Fig. 9 is a sectional view showing a structure of an X-ray analyzing chamber according to the third embodiment of the invention.
Fig. 10 is a sectional view showing a structure of a plasma doping chamber according to a fourth embodiment of the invention.
Fig. 11 is a chart showing a relationship between a depth and a bias voltage according to a fifth embodiment of the invention.
Fig. 12 is a flowchart showing a method according to the fifth embodiment of the invention.
Fig. 13 is a chart showing a result of a measurement for a depth according to the fifth embodiment of the invention.
Fig. 14 is a chart showing a relationship between an implanting depth and a power according to a sixth embodiment of the invention.
Fig. 15 is a chart showing a relationship between a depth of an amorphous layer and a power according to the sixth embodiment of the invention.
Fig. 16 is a chart showing a relationship between an implanting depth of boron and the depth of the amorphous layer according to the sixth embodiment of the invention.
Fig. 17 is a flowchart showing a method according to the sixth embodiment of the invention.
Fig. 18 is a chart showing a result of a measurement of a depth according to the sixth embodiment of the invention.
Fig. 19 is a sectional view showing a structure of a plasma doping apparatus used in a conventional example.
Fig. 20 is a sectional view showing the structure of the plasma doping apparatus used in the conventional example.
Fig. 21 is a chart showing a result of a measurement of a depth in the plasma doping apparatus used in the conventional example.

<EXPLANATION OF DESIGNATIONS>

| 1 | vacuum chamber |
|---|---|
| 2 | gas supplying device |
| 3 | turbo molecular pump |
| 4 | pressure regulating valve |
| 5 | high frequency power supply |
| 6 | sample electrode |
| 7 | dielectric window |
| 8 | coil |

9      substrate
10     high frequency power supply
11     exhaust port

<BEST MODE FOR CARRYING OUT THE INVENTION>

An embodiment according to the invention will be described below in detail with reference to the drawings.

(First Embodiment)

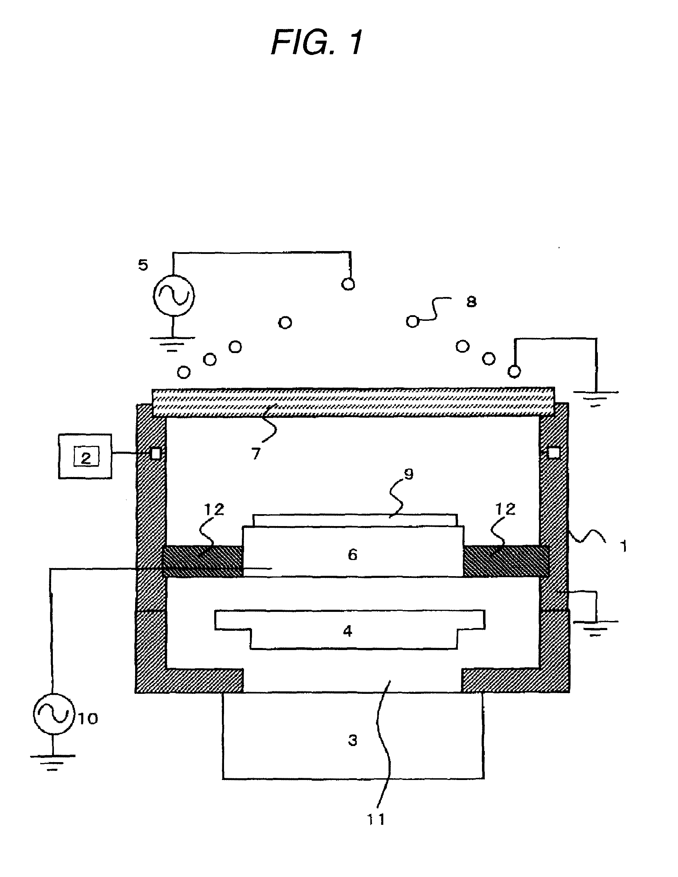

A first embodiment according to the invention will be described below with reference to Figs. 1 to 5.
Fig. 1 is a sectional view showing a plasma irradiating chamber of a plasma doping apparatus used in the first embodiment according to the invention. In Fig. 1, it is possible to discharge air by a turbo molecular pump 3 to be an exhaust device while introducing a predetermined gas from a gas supplying device 2 into a vacuum chamber 1, thereby maintaining an inside of the vacuum chamber 1 to have a predetermined pressure by means of a pressure regulating valve 4. By supplying a high frequency power of 13.56 MHz to a coil 8 provided in the vicinity of a dielectric window 7 opposed to a sample electrode 6 by means of a high frequency power supply 5, it is possible to generate an inductively coupled plasma in the vacuum chamber 1. A silicon substrate 9 is mounted as a sample on the sample electrode 6. Moreover, a high frequency power supply 10 for supplying a high frequency power to the sample electrode 6 is provided and functions as a voltage source for controlling an electric potential of the sample electrode 6 in such a manner that the substrate 9 to be the sample has a negative potential with respect to the plasma. Thus, it is possible to accelerate and collide an ion in the plasma toward a surface of the sample, thereby causing the surface of the sample to be amorphous and to introduce an impurity. The gas supplied from the gas supplying device 2 is discharged from an exhaust port 11 to the pump 3. The turbo molecular pump 3 and the exhaust port 11 are disposed under the sample electrode 6, and furthermore, the pressure regulating valve 4 is an elevating valve positioned under the sample electrode 6 just above the turbo molecular pump 3. The sample electrode 6 is fixed to the vacuum chamber 1 through four columns 12.
After the substrate 9 is mounted on the sample electrode 6, an inner part of the vacuum chamber 1 is exhausted through the exhaust port 11 with a temperature of the sample electrode 6 maintained to be 25□, and at the same time, a helium gas is supplied in 50 sccm from the gas supplying device 2 into the vacuum chamber 1 to control the pressure regulating valve 4, thereby maintaining a pressure in the vacuum chamber 1 to be 1 Pa. Next, 800W of a high frequency power is supplied to the coil 8 to be a plasma source, thereby generating a plasma in the vacuum chamber 1, and furthermore, 200W of a high frequency power is supplied to a pedestal of the sample electrode 6 so that a crystal layer on the surface of the silicon substrate 9 can be brought to be amorphous.

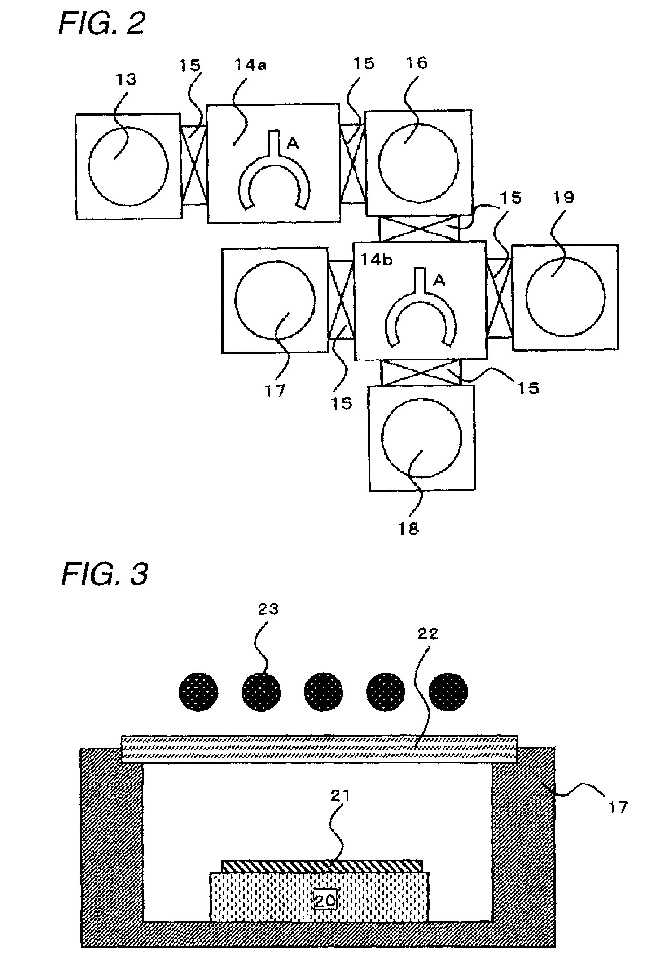

Fig. 2 is a plan view showing a whole structure of the plasma doping apparatus. In Fig. 2, the sample is mounted in a loader chamber 13, and the loader chamber 13 is then exhausted to bring a vacuum state. A gate 15 provided between a first transfer chamber 14a and the loader chamber 13 is opened and a delivery arm A in the first transfer chamber 14a is operated to move the sample into the first transfer chamber 14a. In the same manner, subsequently, the gate 15 is properly opened and closed, and furthermore, the delivery arm A is operated to move the sample into a plasma irradiating chamber 16 and an amorphizing treatment is thus carried out as described above. Next, the sample is moved from the plasma irradiating chamber 16 to a second transfer chamber 14b. Furthermore, the sample is moved to an unloader chamber 19 and is taken out.
On the other hand, an optical characteristic and a depth of an amorphous layer were monitored by using a dummy sample in order to accurately control a characteristic of the amorphous layer. The cause of a change in the optical characteristic and the depth on the same treating conditions includes an adhesion of a deposited substance on an internal wall of a vacuum chamber, a change in a temperature of the internal wall of the vacuum chamber, and a change in a characteristic of a high frequency power supply and cannot be easily specified. The dummy sample was put in every time 25 samples were treated. For the dummy sample, there was used a single crystal silicon substrate having an almost equal size to a sample for forming a device. For the dummy sample, a resist was not subjected to patterning but an amorphizing treatment was carried out over a whole surface of the sample.
First of all, in Fig. 2, the dummy sample was mounted in the loader chamber 13, and the loader chamber 13 was then exhausted to bring a vacuum state. The gate 15 provided between the first transfer chamber 14a and the loader chamber 13 is opened and the delivery arm A in the first transfer chamber 14a is operated to move the dummy sample into the first transfer chamber 14a. In the same manner, subsequently, the gate 15 is properly opened or closed, and furthermore, the delivery arm A is operated to move the dummy sample to the plasma irradiating chamber 16, and the amorphizing treatment is thus carried out on the condition that the sample is treated immediately therebefore. Next, the dummy sample is moved from the plasma irradiating chamber 16 to the second transfer chamber 14b, and furthermore, is moved to an inspecting chamber 17. The dummy sample thus inspected is moved to the second transfer chamber 14b again in Fig. 2. In addition, the dummy sample is moved to the unloader chamber 19 and is then taken out.
Fig. 3 is a sectional view showing a structure of a heating chamber of a lamp annealing type. In Fig. 3, a dummy sample 21 is mounted on a sample table 20 provided in a heating chamber 17. An infrared light emitted from a lamp 22 to be a sample heating device is irradiated on a surface of the dummy sample 21 through a window 21. As an example of the lamp 22, it is possible to use a tungsten halogen lamp. A lamp light irradiating condition is set in such a manner that the temperature of the sample 9 is 1100□ and an activation is carried out on a condition that the temperature is held to be 1100□ for three minutes.

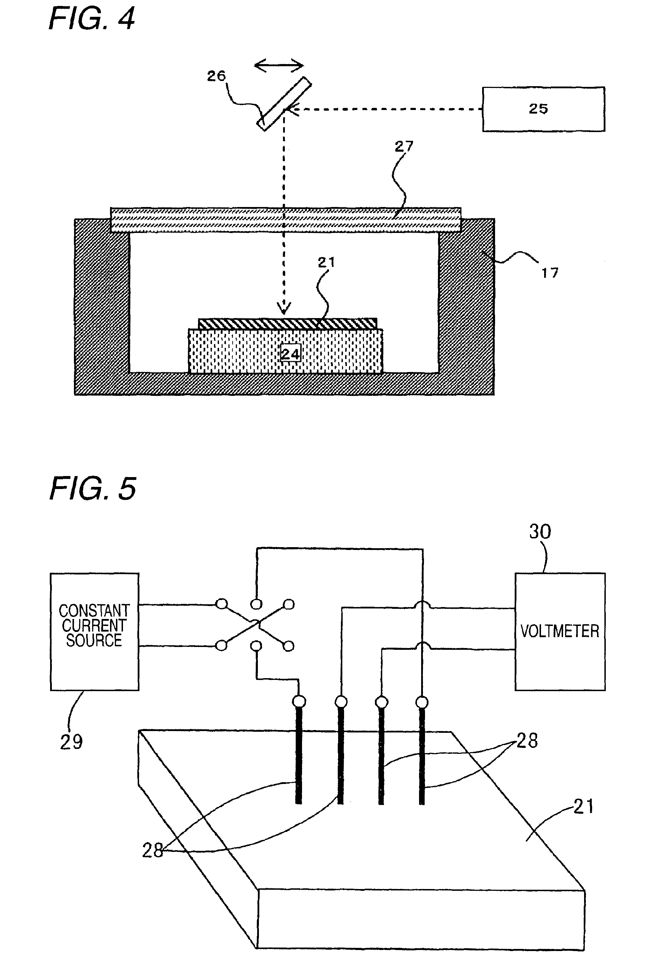

The heating chamber may be of a laser annealing type shown in Fig. 4. In Fig. 4, the dummy sample 21 is mounted on a sample table 24 provided in the heating chamber 17. A direction of a laser beam emitted from a laser beam source 25 to be a sample heating device is controlled by a mirror 26 and the laser beam is irradiated on the surface of the dummy sample 21 through a window 27.

Alternatively, the heating chamber may be a high temperature furnace utilizing a ceramics heater. In the case in which a lamp or a laser is used, it is also possible to heat only the surface of the dummy sample to a high temperature by applying an energy to the dummy sample on a pulse basis. In the case in which the high temperature furnace is used, however, the whole dummy sample is heated. There is an advantage that the high temperature furnace is inexpensive.

The dummy sample subjected to the activating treatment through heating is moved to the second transfer chamber 14b again and is then moved to a sheet resistance measuring chamber 18 in Fig. 2.

Fig. 5 is a perspective view showing a schematic structure of a sheet resistance measuring device provided in the sheet resistance measuring chamber 18. In Fig. 5, four probes 28 are arranged straight on the surface of the dummy sample 21 and two outer probes 28 are connected to a constant current source 29, and a voltage between two inner probes 28 is measured by a voltmeter 30 in an application of a current to the dummy sample 21. More accurately, average values of an applied current value I applied positively and negatively between the two outer probes pressed against the dummy sample 21 and a potential difference measured value V between the two inner probes at this time are obtained and a sheet resistance R of the dummy sample is calculated by the following equation.

$$R = V / I$$

In order to cause the optical characteristic and depth of the amorphous layer to have desirable values with an excellent repeatability, a plasma doping treatment is carried out over the dummy sample every time 25 samples are treated, and a condition for treating the sample is controlled in such a manner that the optical characteristic and the depth of the amorphous layer of the dummy sample subjected to the plasma doping treatment have predetermined values. More specifically, in the case in which the depth of the amorphous layer of the dummy sample is smaller than the desirable value, a power to be supplied to the sample electrode is increased on a condition for treating 25 subsequent samples. Alternatively, a high frequency power to be supplied to a plasma source is reduced. Alternatively, a time required for the treatment is prolonged.

To the contrary, in the case in which the depth of the amorphous layer of the dummy sample is greater than the desirable value, the power to be supplied to the sample electrode is reduced on the condition for treating 25 subsequent samples. Alternatively, the high frequency power to be supplied to the plasma source is increased. Alternatively, the time required for the treatment is shortened.

Referring to a way for changing the power to be supplied to the sample electrode, the high frequency power to be supplied to the plasma source or the time required for the treatment, it is preferable to previously and experimentally obtain a degree of a change in the depth of the amorphous layer in the case in which each of the control parameters is varied on a standard amorphizing condition. In order to change the control parameters, it is preferable to build such a software that a treating recipe stored in a control system of a device which is not shown is rewritten automatically.

By the structure, it is possible to implement a plasma doping method which is excellent in a controllability of the depth of the amorphous layer to be formed on the surface of the sample.

Referring to the way for changing the power to be supplied to the sample electrode, the high frequency power to be supplied to the plasma source or the time required for the treatment, moreover, it is preferable to previously and experimentally obtain a degree of a change in the optical characteristic of the surface in the case in which each of the control parameters is changed on the standard amporphizing condition. In order to change the control parameters, it is preferable to build such a software that a treating recipe stored in a control system of a device which is not shown is rewritten automatically.

By the structure, it is possible to implement a plasma doping method which is excellent in a controllability of the optical characteristic of the surface to be formed on the surface of the sample.

(Second Embodiment)

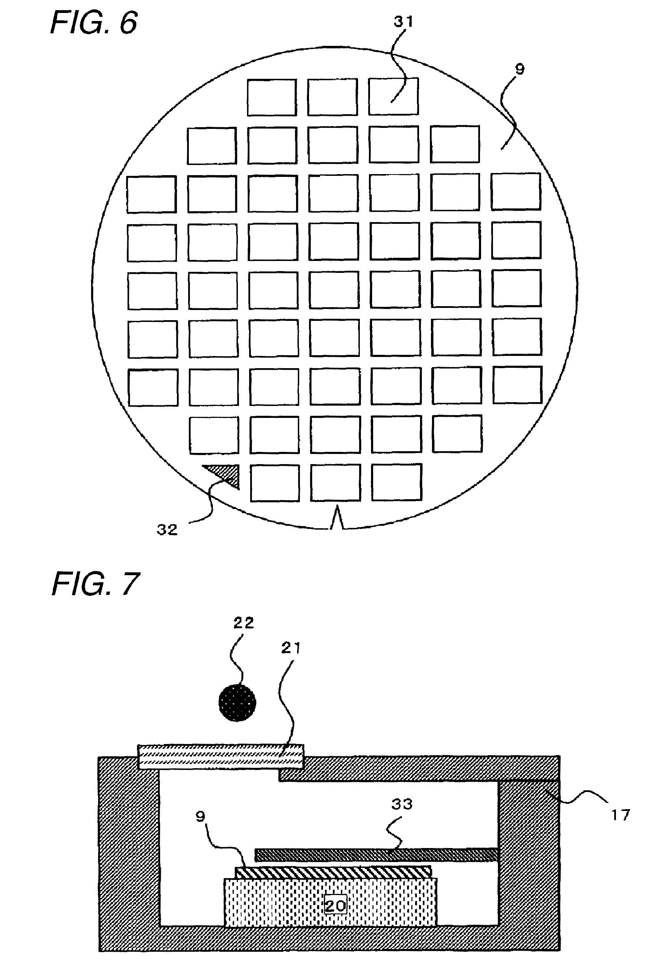

Next, a second embodiment according to the invention will be described with reference to Figs. 6 and 7.

In the first embodiment, the description has been given to the case in which the single crystal silicon substrate having the almost equal size to a sample for forming a device is used as the dummy sample. In the case of the structure, however, there is a drawback that a cost of the dummy sample is increased when an expensive sample such as a 300 mm silicon substrate is to be treated. In order to reduce the cost, for example, a method of reducing a frequency for putting in the dummy sample, for example, treating the dummy sample every time 100 samples are treated can be proposed. However, there is caused another drawback that a controllability of a depth of an amorphous layer is deteriorated.

As a method of solving the problems, it is possible to propose a structure in which the dummy sample is a part of a sample provided in a portion which is not required for a device of the sample. By the structure, it is possible to minimize the cost of the dummy sample when treating an expensive sample such as the 300 mm silicon substrate. If the dummy sample is prepared for a part of the whole sample, moreover, the controllability of the depth of the amorphous layer is increased considerably. In other words, it is possible to finely regulate treating conditions for each sheet.

Fig. 6 is a plan view showing a sample used in the second embodiment and a silicon substrate to be a dummy sample. A large number of chip portions 31 which are to be partitioned into semiconductor elements later are provided in a sample 9. For the chip portion 31, an opening for introducing an impurity is prepared by a resist. In general, a semiconductor substrate takes a circular shape, while the element takes a square shape. For this reason, a portion which cannot be provided with the chip portion is present in a peripheral part of the substrate. A part of the portion can be utilized as a dummy sample 32. A resist pattern is not formed in the dummy sample 32, and an amorphization and a plasma doping treatment are carried out over the whole dummy sample 32.

The amorphization and the plasmas doping treatment are carried out by using the substrate, and a partial heat treatment is then executed in a heating chamber 17 shown in Fig. 7. In Fig. 7, the sample 9 is mounted on a sample table 20 provided in the heating chamber 17. An infrared light emitted from a lamp 22 to be a sample heating device is irradiated on a part of a surface of the sample 9 via a window 21. At this time, the sample 9 is covered with a mask 33 in such a manner that the lamp light is irradiated on only the dummy sample. By using a technique of a flash lamp, it is possible to heat only the surface of the dummy sample to be 1000☐ or more by rarely heating the chip portion. As a matter of course, a laser annealing method can also be used as a method of carrying out the partial heat treatment. In this case, it is preferable to irradiate a laser on only the dummy sample by means of a mirror 26 by utilizing the heating chamber having the structure shown in Fig. 4.

It is desirable that the dummy sample should be heated in an inert gas atmosphere. Consequently, it is possible to suppress a degeneration of the dummy sample which is not preferable, for example, an oxidation. Therefore, it is possible to carry out an activation which is excellent in a reproducibility and to enhance a controllability of an impurity concentration more greatly. In order to carry out the treatment, it is desirable to employ a structure in which a heating chamber includes a gas supplying device for supplying an inert gas into the heating chamber. Alternatively, the same advantages can be obtained even if heating is carried out in a vacuum.

(Third Embodiment)

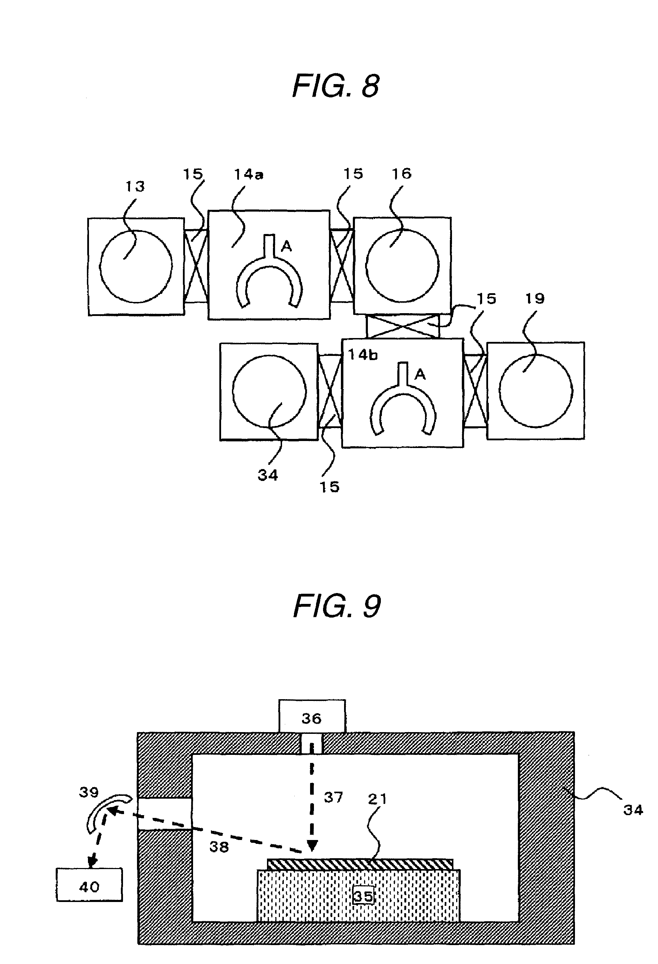

A third embodiment according to the invention will be described below with reference to Figs. 8 and 9.
Since a plasma doping chamber of a plasma doping apparatus for carrying out an amorphization and plasma doping is the same as that in Fig. 1 described in the first embodiment according to the invention, description will be omitted.
Fig. 8 is a plan view showing a whole structure of the plasma doping apparatus. In Fig. 8, a sample is mounted in a loader chamber 13, and the loader chamber 13 is then exhausted to bring a vacuum state. A gate 15 provided between a first transfer chamber 14a and the loader chamber 13 is opened and a delivery arm A in the first transfer chamber 14a is operated to move the sample into the first transfer chamber 14a. In the same manner, subsequently, the gate 15 is properly opened and closed, and furthermore, the delivery arm A is operated to move the sample into a plasma doping chamber 16 and an amorphizing treatment and a plasma doping treatment are thus carried out. Next, the sample is moved from the plasma doping chamber 16 to a second transfer chamber 14b. In addition, the sample is moved to an unloader chamber 19 and is taken out.
On the other hand, a difference in a polarizing state between an incident light and a reflected light is monitored through an ellipsometry by using a dummy sample in order to accurately control a depth of the amorphous layer obtained by the amorphizing treatment. The cause of a change in the depth and the surface condition of the amorphous layer on the same treating conditions includes an adhesion of a gas or a deposited substance on an internal wall of a vacuum chamber and a change in a characteristic of a high frequency power supply and cannot be easily specified. The dummy sample was put in every time 25 samples were treated. For the dummy sample, there was used a single crystal silicon substrate having an almost equal size to a sample for forming a device. For the dummy sample, a resist was not subjected to patterning but the amorphizing treatment and the doping treatment were carried out over a whole surface of the sample.
First of all, in Fig. 8, the dummy sample was mounted in the loader chamber 13, and the loader chamber 13 was then exhausted to bring a vacuum state. The gate 15 provided between the first transfer chamber 14a and the loader chamber 13 is opened and the delivery arm A in the first transfer chamber 14a is operated to move the dummy sample into the first transfer chamber 14a. In the same manner, subsequently, the gate 15 is properly opened or closed, and furthermore, the delivery arm A is operated to move the dummy sample to the plasma doping chamber 16, and the amorphizing treatment and the plasma doping treatment are thus carried out on the condition that the sample is treated immediately therebefore. Next, the dummy sample is moved from the plasma doping chamber 16 to the second transfer chamber 14b, and furthermore, is moved to an X-ray analyzing chamber 34.

Fig. 9 is a sectional view showing a structure of the inspecting chamber 34 for carrying out the ellipsometry. In Fig. 9, a dummy sample 21 is mounted on a sample table 35 provided in the inspecting chamber 34. A light beam 37 irradiated from a light source 36 is exposed to an amorphous layer which is amorphized by a modifying treatment in a depth of 3 nm to 100 nm of a surface of the dummy sample 21. When a linearly polarized light is incident, a reflected light is an elliptically polarized light. By measuring a tangent obtained from a phase angle $\Delta$ of the elliptically polarized light and an amplitude intensity ratio of an ellipse and detecting a thickness and a double refraction index of the amorphous layer using a detector constituted by an analyzer 39 and a detector 40, it is possible to know the depth and the surface condition of the amorphous layer on the surface of the dummy sample.

According to the ellipsometry method, it is possible to detect the depth and the surface condition (optical characteristic) of the amorphous layer.

The dummy sample in which the depth and the surface condition of the amorphous layer are detected and a dose is measured if necessary is moved to the second transfer chamber 14b again and is subsequently moved to the unloader chamber 19, and is thus taken out of the device in Fig. 8.

In order to obtain a desirable depth of the amorphous layer, the measured value obtained by the ellipsometry is to be a desirable value. Therefore, there is controlled a condition for carrying out a plasma doping treatment over the dummy sample every time 25 samples are treated, irradiating a linearly polarized light on the dummy sample subjected to the plasma doping treatment, detecting a reflected light discharged from the dummy sample, and treating the sample in such a manner that the depth and the surface condition of the amorphous layer which are detected have predetermined values.

More specifically, in the case in which the depth of the amorphous layer of the dummy sample is greater than the desirable value, a power to be supplied to the sample electrode is reduced on a condition for treating 25 subsequent samples. Alternatively, a high frequency power to be supplied to a plasma source is increased. Alternatively, a time required for the treatment is shortened.

To the contrary, in the case in which the depth of the amorphous layer of the dummy sample is smaller than the desirable value, the power to be supplied to the sample electrode is increased on the condition for treating 25 subsequent samples. Alternatively, the high frequency power to be supplied to the plasma source is reduced. Alternatively, the time required for the treatment is prolonged.

Referring to a way for changing the power to be supplied to the sample electrode, the high frequency power to be supplied to the plasma source or the time required for the treatment, it is preferable to previously and experimentally obtain a degree of a change in the depth of the amorphous layer and a polarizing state in the case in which each of the control parameters is varied on a standard amorphizing condition and a doping condition. In order to change each of the control parameters, it is preferable to build such a software that a treating recipe stored in a control system of a device which is not shown is rewritten automatically.

By the structure, it is possible to implement a plasma doping method which is excellent in a controllability of the depth of the amorphous layer to be introduced into the surface of the sample.

(Fourth Embodiment)

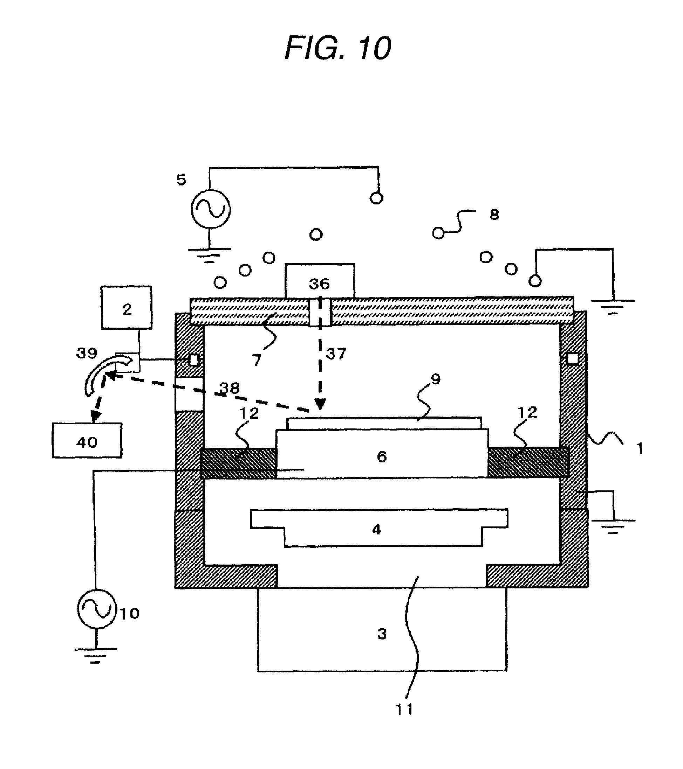

Next, a fourth embodiment according to the invention will be described with reference to Fig. 10.

Fig. 10 is a sectional view showing a plasma doping chamber of a plasma doping apparatus used in the fourth embodiment according to the invention. In Fig. 10, it is possible to discharge air by a turbo molecular pump 3 to be an exhaust device while introducing a predetermined gas from a gas supplying device 2 into a vacuum chamber 1, thereby maintaining an inside of the vacuum chamber 1 to have a predetermined pressure by means of a pressure regulating valve 4. By supplying a high frequency power of 13.56 MHz to a coil 8 provided in the vicinity of a dielectric window 7 opposed to a sample electrode 6 by means of a high frequency power supply 5, it is possible to generate an inductively coupled plasma in the vacuum chamber 1.

A silicon substrate 9 is mounted as a sample on the sample electrode 6. Moreover, a high frequency power supply 10 for supplying a high frequency power to the sample electrode 6 is provided and functions as a voltage source for controlling an electric potential of the sample electrode 6 in such a manner that the substrate 9 to be the sample has a negative potential with respect to the plasma. Thus, it is possible to accelerate and collide an ion in the plasma toward a surface of the sample, thereby causing the surface of the sample to be amorphous and to introduce an impurity.

The gas supplied from the gas supplying device 2 is discharged from an exhaust port 11 to the pump 3. The turbo molecular pump 3 and the exhaust port 11 are disposed under the sample electrode 6, and furthermore, the pressure regulating valve 4 is an elevating valve positioned under the sample electrode 6 just above the turbo molecular pump 3. The sample electrode 6 is fixed to the vacuum chamber 1 through four columns 12.

After the substrate 9 is mounted on the sample electrode 6, an inner part of the vacuum chamber 1 is exhausted through the exhaust port 11 with a temperature of the sample electrode 6 maintained to be 25☐, and at the same time, a helium gas is supplied in 50 sccm from the gas supplying device 2 into the vacuum chamber 1 to control the pressure regulating valve 4, thereby maintaining a pressure in the vacuum chamber 1 to be 1 Pa. Next, 800W of a high frequency power is supplied to the coil 8 to be a plasma source, thereby generating a plasma in the vacuum chamber 1, and furthermore, 200W of a high frequency power is supplied to a pedestal 16 of the sample electrode 6 so that a crystal layer on the surface of the silicon substrate 9 can be brought to be amorphous.

Subsequently, a helium (He) gas and a $B_2H_6$ gas are supplied in amounts of 100 sccm and 1 sccm into the vacuum chamber 1 with a temperature of the sample electrode 6 maintained to be 25☐ respectively and 1000 W of a high frequency power is supplied to the coil 8 with a pressure in the vacuum chamber 1 maintained to be 0.5 Pa. By generating a plasma in the vacuum chamber 1 and supplying 250W of a high frequency power to the sample electrode 6, consequently, it is possible to introduce boron to the vicinity of the surface of the substrate 9.

A plasma doping chamber includes a detector constituted by an analyzer 39 and a detector 40 which serve to measure the depth of the amorphous layer by carrying out the ellipsometry. Since the operation has been described in the third embodiment according to the invention, description will be omitted. In the same manner, moreover, the detector constituted by the analyzer 39 and the detector 40 may be provided as a device for measuring X rays to be radiated from the sample in order to calculate a dose (an impurity concentration).

By controlling the condition for amorphizing the sample in such a manner that the depth of the amorphous layer calculated from the polarizing state thus measured has a predetermined value, it is possible to implement a preamorphizing method which is excellent in a controllability of the depth of the amorphous layer to be formed on the surface of the sample and a plasma doping method having an excellent controllability. In general, a portion for carrying out the amorphization and the introduction of an impurity is opened on the surface of the sample by a resist. A larger opening portion is provided in order to easily measure the depth of the amorphous layer, the amount of X rays or the dose calculated from the amount of X rays (the opening portion serves as the dummy sample).

In the case in which the depth of the amorphous layer is smaller than the desirable value, a power to be supplied to the sample electrode is reduced on a condition for treating a predetermined number of subsequent samples. Alternatively, a high frequency power to be supplied to a plasma source is increased. Alternatively, a time required for the treatment is shortened.

To the contrary, in the case in which the depth of the amorphous layer is smaller than the desirable value, the power to be supplied to the sample electrode is increased on the condition for treating a predetermined number of subsequent samples. Alternatively, the high frequency power to be supplied to the plasma source is reduced. Alternatively, the time required for the treatment is prolonged.

Referring to a way for changing the power to be supplied to the sample electrode, the high frequency power to be supplied to the plasma source or the time required for the treatment, it is preferable to previously and experimentally obtain a degree of a change in the depth of the amorphous layer in the case in which each of the control parameters is varied on a standard amorphizing condition and a doping condition. In order to change each of the control parameters, it is preferable to build such a software that a treating recipe stored in a control system of a device which is not shown is rewritten automatically.

Consequently, it is possible to implement a plasma doping treatment having an excellent reproducibility.

With the structure in which a detector using the ellipsometry, an electron beam source and an X-ray detector irradiate a light toward the sample mounted on the sample electrode in the vacuum chamber, thus, a special treating chamber for measuring the depth of the amorphous layer is not required so that a productivity can be enhanced.

According to the method, there is employed the structure in which the dummy sample is a part of the sample provided in a portion which is not required for a device of the sample. By the structure, it is possible to minimize the cost of the dummy sample when treating an expensive sample such as the 300 mm silicon substrate. If the dummy sample is prepared for a part of the whole sample, moreover, the controllability of the impurity concentration is increased considerably. In other words, it is possible to finely regulate treating conditions for each sheet.

It is apparent that a substrate having no resist formed thereon may be used as the dummy sample.

In the embodiments according to the invention, a part of variations related to a shape of a vacuum chamber, a method and arrangement of a plasma source and a plasma condition in the scope of the invention is only illustrative. In an application of the invention, it is apparent that the other variations can be proposed.

For example, the coil 8 may take a planar shape, a helicon wave plasma source, a magnetically neutral loop plasma source and a magnetoactive microwave plasma source (an electron cyclotron resonance plasma source) may be used, or a parallel plate type plasma source shown in Fig. 9 may be used.

Moreover, an inert gas other than helium may be used and at least one of neon, argon, krypton and xenon gases can be used. The inert gases have an advantage that they have a bad influence on a sample which is smaller than the other gases.

Furthermore, the invention can also be applied to the case in which boron is doped simultaneously with the amorphization by using a gas plasma in which diboron is mixed with helium, for example. Thus, the application is desirable because only one step is required in place of two steps and a productivity can be enhanced.

While the case in which the sample is the semiconductor substrate formed of silicon has been illustrated, moreover, the invention can be applied when samples formed by other various materials are to be treated. However, the invention provides a particularly useful plasma doping method in the case in which the sample is a semiconductor substrate formed of silicon. In the case in which an impurity is arsenic, phosphorus, boron, aluminum or antimony, furthermore, the invention is particularly useful. By the structure, it is possible to manufacture a hyperfine silicon semiconductor apparatus.

Moreover, an emission spectral analysis of a plasma or a mass analysis may be carried out during a doping treatment to monitor a vapor phase state and to use the vapor phase state for a decision as to any of parameters to be changed. If a sheet resistance value is changed irrespective of no special change in the vapor phase state, for example, it is preferable to change a power to be supplied to a sample electrode without varying a gas flow rate or a high frequency power to be supplied to a plasma source. To the contrary, if the change in the vapor phase state is observed, it is preferable to change the gas flow rate or the high frequency power to be supplied to the plasma source without varying the power to be supplied to the sample electrode.

While the description has been given to the case in which the amorphization and the doping treatment are continuously carried out in the same plasma treating chamber, moreover, separate plasma treating chambers may be prepared to carry out the treatments separately.

While the description has been given to the case in which the heating chamber and the sheet resistance measuring chamber are provided separately, furthermore, a sheet resistance measuring device may be provided in the heating chamber.

In addition, it is apparent that variations can be proposed for the structure of the whole apparatus.

(Fifth Embodiment)

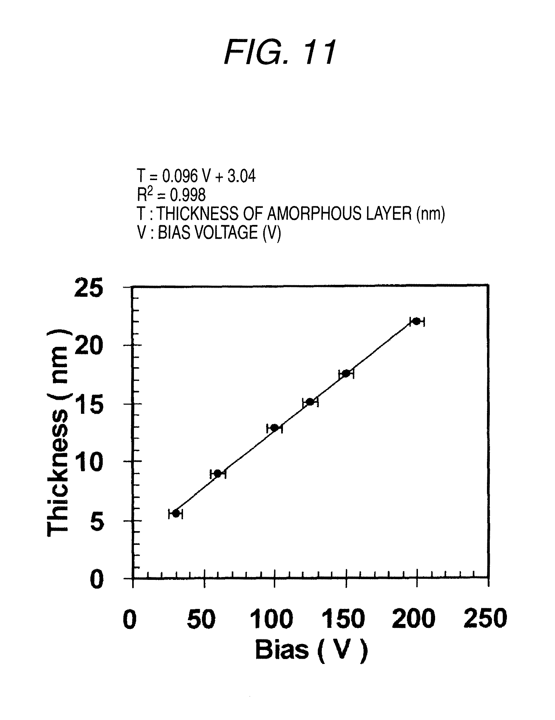

Next, a fifth embodiment according to the invention will be described with reference to Figs. 11, 12 and 13. In the fifth embodiment, the first embodiment will be described in more detail. Therefore, a movement of a dummy sample is the same as that in the first embodiment.

Plasma doping was carried out over a silicon substrate having a size of 200 mm by using a helium gas plasma. The plasma doping was performed in a vacuum chamber 1 of a plasma irradiating chamber 16. A high frequency power to be supplied to a plasma source was set to be 1500W, a pressure of the vacuum chamber 1 was set to be 0.9 Pa and a treating time required for carrying out a plasma irradiation was set to be seven seconds. A power to be supplied to a sample electrode was changed within a range of 30W to 300W. By varying the power to be supplied to the sample electrode, it is possible to change a bias voltage generated between a plasma and the silicon substrate. The bias voltage is raised when the power to be supplied to the sample electrode is increased, and is reduced when the same power is decreased. The power to be supplied to the sample electrode is changed within the range of 30W to 300W so that the bias voltage is changed within a range of 30V to 200V.

After the plasma doping treatment was thus carried out over a dummy sample, the dummy sample was moved to an inspecting chamber 17 to measure a depth of an amorphous layer by using an ellipsometry. As a result of the experiment, it was found that the bias voltage and the depth of the amorphous layer have a relationship shown in Fig. 11.

The bias voltage and the depth of the amorphous layer have a very excellent proportional relationship. It can be understood that the depth of the amorphous layer is changed by approximately 0.1 mm with a change in the bias voltage by 1V. In order to change the bias voltage by 1 V, it is preferable to change the power to be supplied to the sample electrode by approximately 1.5W. More specifically, it can be understood that the depth of the amorphous layer can be controlled with very high precision on a unit of 0.1 nm by a change in the power to be supplied to the sample electrode.

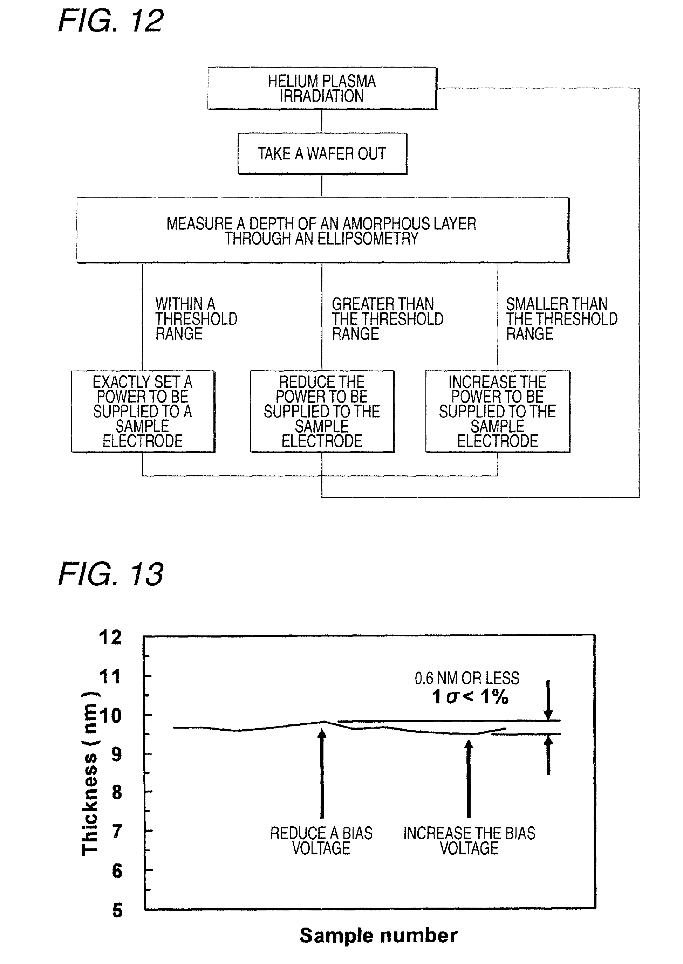

Fig. 12 is a flowchart showing a method of improving a repetitive reproducibility of the depth of the amorphous layer by combining the relationship between the power to be supplied to the sample electrode which is obtained previously and experimentally as described above and the depth of the amorphous layer and the inspection using the ellipsometry. Referring to the inspection using the ellipsometry, if the depth of the amorphous layer is within a range of a predetermined threshold which is set, the power to be supplied to the sample electrode is exactly maintained. If the depth is greater than the threshold, the power to be supplied to the sample electrode is reset to be low. If the depth is smaller than the threshold, the power to be supplied to the sample electrode is reset to be high.

More specifically, as shown in Fig. 12, a helium gas plasma irradiation is first carried out (Step 101), a wafer is taken out of an apparatus (Step 102), and the depth of the amorphous layer is measured by the inspection using the ellipsometry (Step 103).

It is decided whether the depth of the amorphous layer measured at the measuring step 103 is within a range of a predetermined threshold which is set or not (Step 104). If the depth is within the range of the predetermined threshold, the power to be supplied to the sample electrode is exactly maintained (Step 105).

If it is decided that the depth is not within the range of the predetermined threshold, it is decided whether the depth is greater than the threshold or not (Step 106). If it is decided that the depth is greater than the threshold at the deciding step, the power to be supplied to the sample electrode is reset to be low (Step 107). On the other hand, if it is decided that the depth is smaller than the threshold at the deciding step 206, the power to be supplied to the sample electrode is reset to be high (Step 108).

Fig. 13 shows a result obtained by thus repeating the formation of the amorphous layer through the plasma doping treatment, the inspection using the ellipsometry and a feedback of a result of the inspection. The plasma doping treatment was carried out over 100 silicon substrates, and one inspection using the ellipsometry and one feedback of the result of the inspection were executed for each plasma doping treatment. During 100 plasma doping treatments, a bias voltage was changed twice, that is, the power to be supplied to the sample electrode was varied. At a first time, since the depth of the amorphous layer was greater than the threshold, the bias voltage was reduced by 2V

More specifically, the power to be supplied to the sample electrode was reduced by 3W. At another time, since the depth of the amorphous layer was smaller than the threshold, the bias voltage was increased by 2V. More specifically, the power to be supplied to the sample electrode was increased by 3W. As a result, in the case in which 100 amorphous layers were repetitively formed, an average value was 9.6 nm and a difference between a maximum value and a minimum value was equal to or smaller than 0.6 nm. A variation was equivalent to 1% or less in 1σ. This indicates a very high repetitive reproducibility and a validity of the invention.

Moreover, a method of feeding back the result of the inspection to the treating condition has widely been used for other general techniques. However, the invention is characterized in that there are combined a very great proportional relationship between the power to be supplied to the sample electrode and the depth of the amorphous layer and the fact that the depth of the amorphous layer can be variably controlled with very high precision on a unit of 0.1 nm even if the power to be supplied to the sample electrode is changed to be 1.5W which is such a sufficiently great value as to be actually used.

(Sixth Embodiment)

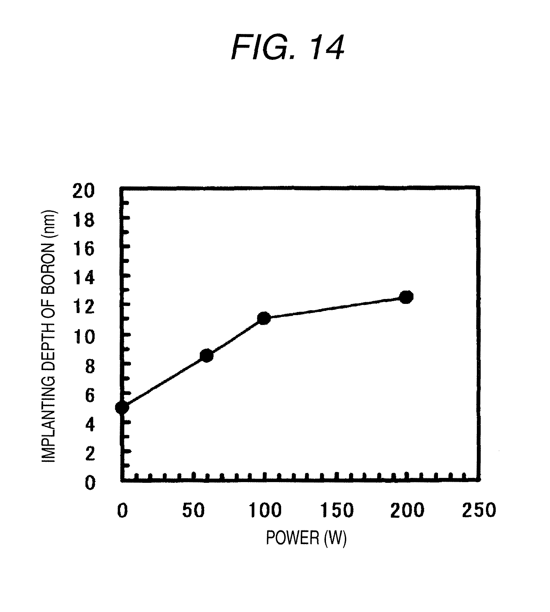

Next, a sixth embodiment according to the invention will be described with reference to Figs. 14, 15, 16, 17 and 18. A movement of a dummy sample is the same as that in the first embodiment.

By using a mixed gas plasma of diboron and helium, plasma doping was carried out over a silicon substrate having a size of 200 mm. As a mixing ratio, a diboron gas concentration was set to be 0.025% and a helium gas concentration was set to be 99.975%. The plasma doping was carried out in a vacuum chamber 1 of a plasma irradiating chamber 16. A high frequency power to be supplied to a plasma source was set to be 1500W, a pressure of the vacuum chamber 1 was set to be 0.9 Pa, and a treating time required for carrying out a plasma irradiation was set to be 30 seconds.

The power to be supplied to the sample electrode was changed within a range of 0W to 200W. On the condition, it is possible to simultaneously carry out an implantation of boron into a silicon substrate through the plasma doping and an amorphization of a silicon crystal on a surface of the silicon substrate. Even if the power to be supplied to the sample electrode is zero, an ion in a plasma is caused to collide with the silicon substrate and is thus implanted therein based on a potential difference made naturally between the silicon substrate and the plasma. After the power to be supplied to the sample electrode was changed to carry out the plasma doping treatment over a dummy sample, the dummy sample was moved to an inspecting chamber 17 to measure a depth of an amorphous layer by using an ellipsometry. Thereafter, a depth profile of the boron in the silicon substrate was measured by an SIMS measuring apparatus which is not shown.

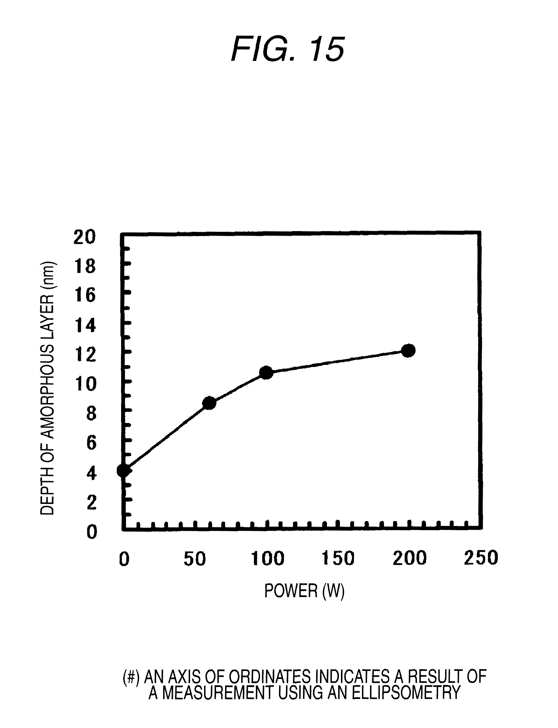

As a result of the experiment, it was found that a relationship between the power to be supplied to the sample electrode and the implanting depth of the boron is obtained as shown in Fig. 14. The implanting depth of the boron was set in such a manner that a boron concentration was $1 \times 10^{18}$ cm$^{-3}$ in the profile measured by the SIMS. This is a way for determining the implanting depth of the boron to be generally used widely in the field of a shallow joining formation in a semiconductor process. The implanting depth of the boron has a one-to-one correspondence to the power to be supplied to the sample electrode, and can be controlled by varying the power to be supplied to the sample electrode. On the other hand, it was found that the power to be supplied to the sample electrode and the depth of the amorphous layer have a relationship shown in Fig. 15. It is also possible to control the depth of the amorphous layer by varying the power to be supplied to the sample electrode.

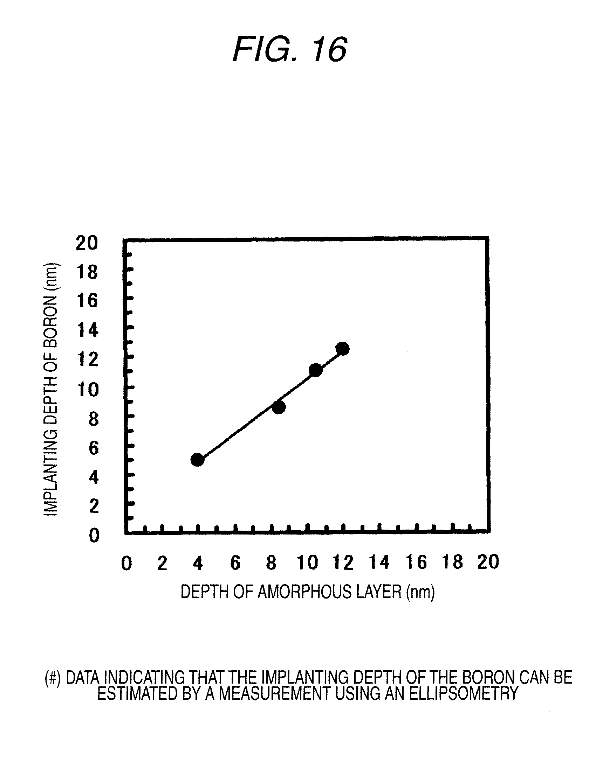

Furthermore, it was found that the depth of the amorphous layer and the implanting depth of the boron have a relationship shown in Fig. 16. Fig. 16 shows that the implanting depth of the boron can be specified when the depth of the amorphous layer is measured. Usually, the implanting depth of the boron is to be measured by using the SIMS. The SIMS requires several hours for one measurement and carries out a destructive inspection. Assuming that the implanting depth of the boron is inspected by the SIMS, a long time is required for the inspection. For this reason, a large number of products are subjected to the plasma doping treatment during the inspection. It is found that the implanting depth of the boron in the product is great when the inspection is ended.

Therefore, it is demanded to carry out the inspection in a shorter time.

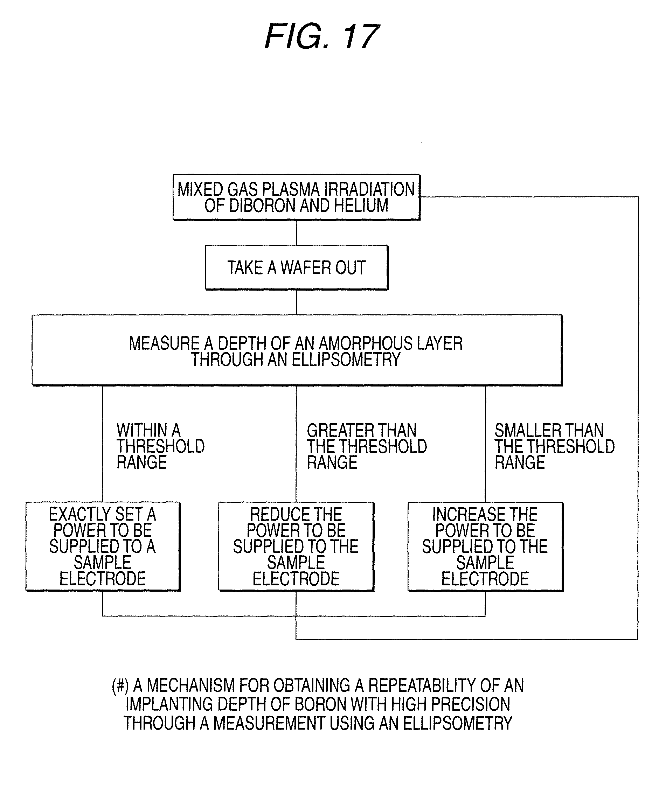

On the other hand, referring to Fig. 16, it is possible to specify the implanting depth of the boron by measuring the depth of the amorphous layer. Therefore, it can be understood that the inspection can be carried out by an optical measurement using an ellipsometry in place of the SIMS. This is a new thought which is peculiar to the invention. Fig. 17 is a flowchart showing a method of improving a repetitive reproducibility of the implanting depth of the boron by using the thought.

In the method, the inspection is carried out in a short time after the plasma doping treatment to feed back the result of the inspection to the plasma doping condition with reference to Fig. 16 which is prepared previously and experimentally. The inspection uses the ellipsometry. In the inspection using the ellipsometry, if the depth of the amorphous layer is within a range of a predetermined threshold which is set, the power to be supplied to the sample electrode is exactly maintained. If the depth is greater than the threshold, the power to be supplied to the sample electrode is reset to be low. If the depth is smaller than the threshold, the power to be supplied to the sample electrode is reset to be high.

More specifically, as shown in Fig. 17, a helium gas plasma irradiation is first carried out (Step 201), a wafer is taken out of an apparatus (Step 202), and the depth of the amorphous layer is measured by the inspection using the ellipsometry (Step 203).

It is decided whether the depth of the amorphous layer measured at the measuring step 203 is within a range of a predetermined threshold which is set or not (Step 204). If the depth is within the range of the predetermined threshold, the power to be supplied to the sample electrode is exactly maintained (Step 205).

If it is decided that the depth is not within the range of the predetermined threshold, it is decided whether the depth is greater than the threshold or not (Step 206). If it is decided that the depth is greater than the threshold at the deciding step, the power to be supplied to the sample electrode is reset to be low (Step 207). On the other hand, if it is decided that the depth is smaller than the threshold at the deciding step 206, the power to be supplied to the sample electrode is reset to be high (Step 208).

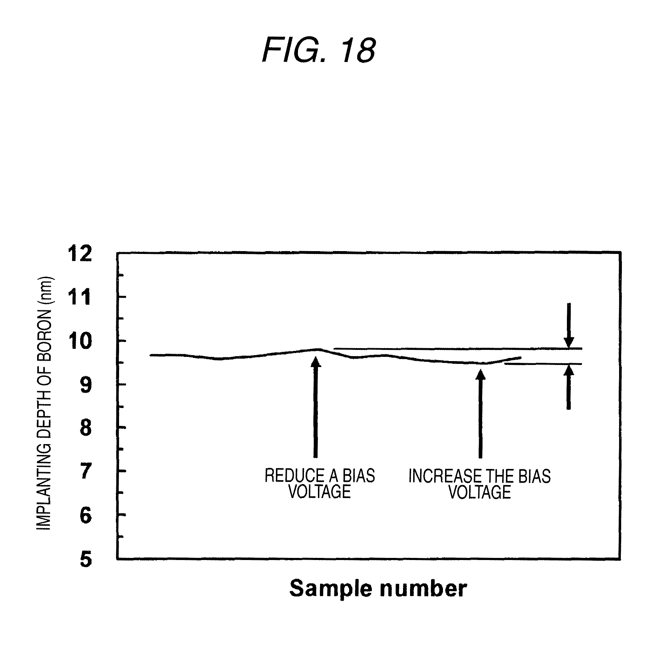

Fig. 18 shows a result obtained by thus repeating the formation of the amorphous layer through the plasma doping treatment, the inspection using the ellipsometry and the feedback of a result of the inspection. The plasma doping treatment was carried out over 100 silicon substrates, and one inspection using the ellipsometry and one feedback of the result of the inspection were executed for each plasma doping treatment.

During 100 plasma doping treatments, a bias voltage was changed twice, that is, the power to be supplied to the sample electrode was varied. At a first time, since the depth of the amorphous layer was greater than the threshold, the bias voltage was reduced by 2V. More specifically, the power to be supplied to the sample electrode was reduced by 3W. At another time, the depth of the amorphous layer was smaller than the threshold. Therefore, the bias voltage was increased by 2V.

In other words, the power to be supplied to the sample electrode was increased by 3W. As a result, in the case in which the repetitive formation of 100 amorphous layers and the implantation of the boron were carried out at the same time, an average value of the implanting depth of the boron was 9.6 nm and a difference between a maximum value and a minimum value was equal to or smaller than 0.6 nm. A variation was equivalent to 1% or less in $1\sigma$. This indicates a very high repetitive reproducibility and a validity of the invention.

Moreover, a method of feeding back the result of the inspection to the treating condition has widely been used for other general techniques. However, the invention is characterized in that the inventors newly found a one-to-one relationship between the depth of the amorphous layer and the implanting depth of the boron in the plasma doping capable of simultaneously carrying out the formation of the amorphous layer and the implantation of the boron which was newly developed and they utilize the finding. Furthermore, the invention is characterized in that the novel finding and the fact that the depth of the amorphous layer and the implanting depth of the boron can be controlled with the power to be supplied to the sample electrode and the depth of the amorphous layer can be measured in a short time by an optical measurement such as an ellipsometry are used in combination.

<INDUSTRIAL APPLICABILITY>

The invention can provide a plasma doping method and apparatus which is excellent in a controllability of an implanting depth of an impurity to be introduced into a surface of a sample or a depth of an amorphous layer. Therefore, the invention can also be applied to uses such as a manufacture of a thin film transistor to be used in a liquid crystal and a modification of surfaces of various materials as well as a step of doping a semiconductor with an impurity.

**Claims**

1. A plasma doping method for generating a plasma in a vacuum chamber and colliding an ion in the plasma with a surface of a sample to modify a surface of a crystal sample to be amorphous, comprising the steps of:

   carrying out a plasma irradiation over a dummy sample to perform an amorphizing treatment together with a predetermined number of samples;
   irradiating a light on a surface of the dummy sample subjected to the plasma irradiation, thereby measuring an optical characteristic of the surface of the dummy sample; and controlling a condition for treating the crystal sample in such a manner that the optical characteristic obtained at the measuring step has a desirable value.

2. The plasma doping method according to claim 1, wherein the step of performing an amorphizing treatment serves to mount a sample on a sample electrode in the vacuum chamber and to accelerate and collide the ion in the plasma toward a surface of the sample to modify the surface of the crystal sample to be amorphous while generating a plasma in the vacuum chamber.

3. The plasma doping method according to claim 1, wherein the step of performing an amorphizing treatment serves to mount a sample on a sample electrode in the vacuum chamber and to exhaust an inner part of the vacuum chamber while supplying a gas into the vacuum chamber by a gas supplying device, to generate a plasma in the vacuum chamber by supplying a power to the sample electrode while controlling the inner part of the vacuum chamber to have a predetermined pressure, and to accelerate and collide an ion in the plasma toward a surface of the sample, thereby modifying the surface of the crystal sample to be amorphous.

4. The plasma doping method according to claim 1, wherein the step of performing an amorphizing treatment serves to mount a sample on a sample electrode in the vacuum chamber and to exhaust an inner part of the vacuum chamber while supplying a gas into the vacuum chamber by a gas supplying device, to generate a plasma in the vacuum chamber by supplying a high frequency power to a plasma source while controlling the inner part of the vacuum chamber to have a predetermined pressure, and to accelerate and collide an ion in the plasma toward a surface of the sample by supplying a power to the sample electrode, thereby modifying the surface of the crystal sample to be amorphous.

5. The plasma doping method according to claim 1, wherein the measuring step serves to control treating conditions of a step of irradiating a light on the surface of the dummy sample subjected to a plasma doping treatment, thereby detecting a difference in a polarizing state between an incident light and a reflected light and calculating a depth of an amorphous layer based on the optical characteristic of the surface of the dummy sample from the difference, and the step of carrying out a modification in such a manner that the depth of the amorphous layer thus calculated has a predetermined value.

6. The plasma doping method according to claim 4, wherein the modifying step includes a step of controlling the treating conditions in order to change an acceleration energy for accelerating the ion in the plasma toward the surface of the sample.

7. The plasma doping method according to claim 4, wherein the modifying step includes a step of controlling the treating conditions in order to change a potential difference which can be regulated with a magnitude of a power formed between the plasma and the sample electrode by varying a power to be supplied to the sample electrode.

8. The plasma doping method according to claim 4, wherein the modifying step includes a step of controlling the treating conditions in order to change a time required for irradiating a plasma.

9. The plasma doping method according to claim 4, wherein the modifying step includes a step of controlling the treating conditions in order to change a high frequency power to be supplied to a plasma source.

10. The plasma doping method according to claim 4, wherein the modifying step includes a step of controlling the treating conditions in order to change a pressure in the vacuum chamber.

11. The plasma doping method according to any of claims 1 to 10, wherein the sample is a semiconductor substrate formed of silicon.

12. The plasma doping method according to any of claims 1 to 10, wherein the plasma to be generated in the vacuum chamber is constituted by an inert gas.

13. The plasma doping method according to claim 12, wherein the plasma to be generated in the vacuum chamber is constituted by helium or neon.

14. The plasma doping method according to claim 1, wherein the plasma to be generated in the vacuum chamber contains an impurity and serves to carry out plasma doping for modifying the surface of the crystal sample to be amorphous, and at the same time, introducing the impurity into the surface of the sample.

15. The plasma doping method according to claim 14, wherein the impurity is boron.

16. The plasma doping method according to claim 14, wherein the plasma contains boron diluted with helium.

**17.** The plasma doping method according to claim 14, wherein the impurity is diboron.

**18.** The plasma doping method according to claim 14, wherein the impurity contains arsenic, phosphorus or antimony.

**19.** The plasma doping method according to claim 1, wherein the dummy sample is a part of a sample provided in an unnecessary portion for a device of the sample.

**20.** The plasma doping method according to any of claims 1 to 19, wherein a depth of the amorphous layer is controlled, thereby controlling a depth of an impurity ion which is introduced.

**21.** A plasma doping method of generating a plasma in a vacuum chamber and colliding an ion in the plasma with a surface of a sample to modify a surface of a crystal sample to be amorphous, comprising the steps of:

carrying out a plasma irradiation over a dummy sample to perform an amorphizing treatment together with a predetermined number of samples;

measuring a depth of an amorphous layer formed on a surface of the dummy sample subjected to the plasma irradiation; and

controlling a condition for treating the crystal sample in such a manner that the depth of the amorphous layer obtained at the measuring step has a desirable value.

**22.** A plasma doping apparatus comprising a vacuum chamber, a sample electrode, a plasma doping chamber including plasma supplying means for supplying a plasma to the sample and a power supply for the sample electrode which serves to supply a power to the sample electrode, a light irradiating portion for irradiating a light on the sample, and a detecting portion for detecting polarizing states of an incident light on the sample and a reflected light.

**23.** The plasma doping apparatus according to claim 22, wherein the plasma doping chamber is provided with gas supplying means for supplying a gas into the vacuum chamber, exhausting means for exhausting an inner part of the vacuum chamber, and pressure control means for controlling a pressure in the vacuum chamber.

**24.** The plasma doping apparatus according to claim 22 or 23, wherein the detecting portion is provided in the plasma doping chamber.

**25.** The plasma doping apparatus according to claim 22 or 23, wherein the detecting portion is provided in an inspecting chamber provided separately from the plasma doping chamber.

# FIG. 1

*FIG. 2*

*FIG. 3*

FIG. 4

FIG. 5

CONSTANT
CURRENT
SOURCE

VOLTMETER

## FIG. 6

## FIG. 7

## FIG. 8

## FIG. 9

## FIG. 10

## FIG. 11

$T = 0.096\,V + 3.04$
$R^2 = 0.998$
T : THICKNESS OF AMORPHOUS LAYER (nm)
V : BIAS VOLTAGE (V)

## FIG. 12

```
┌─────────────────────────┐
│   HELIUM PLASMA         │────────────────────────────────┐
│   IRRADIATION           │                                │
└─────────────────────────┘                                │
            │                                               │
┌─────────────────────────┐                                │
│   TAKE A WAFER OUT       │                                │
└─────────────────────────┘                                │
            │                                               │
┌───────────────────────────────────────────────────┐      │
│   MEASURE A DEPTH OF AN AMORPHOUS LAYER            │      │
│   THROUGH AN ELLIPSOMETRY                          │      │
└───────────────────────────────────────────────────┘      │
      │                    │                    │           │
  WITHIN A            GREATER THAN          SMALLER THAN     │
  THRESHOLD           THE THRESHOLD         THE THRESHOLD    │
  RANGE               RANGE                 RANGE            │
      │                    │                    │           │
┌──────────────┐   ┌──────────────┐   ┌──────────────┐      │
│ EXACTLY SET A│   │ REDUCE THE   │   │ INCREASE THE │      │
│ POWER TO BE  │   │ POWER TO BE  │   │ POWER TO BE  │      │
│ SUPPLIED TO A│   │ SUPPLIED TO  │   │ SUPPLIED TO  │      │
│ SAMPLE       │   │ THE SAMPLE   │   │ THE SAMPLE   │      │
│ ELECTRODE    │   │ ELECTRODE    │   │ ELECTRODE    │      │
└──────────────┘   └──────────────┘   └──────────────┘      │
      └────────────────────┴────────────────────┴───────────┘
```

## FIG. 13

Thickness ( nm ) vs Sample number

0.6 NM OR LESS
$1\sigma < 1\%$

REDUCE A BIAS VOLTAGE

INCREASE THE BIAS VOLTAGE

# FIG. 14

# FIG. 15

(#) AN AXIS OF ORDINATES INDICATES A RESULT OF
A MEASUREMENT USING AN ELLIPSOMETRY

# FIG. 16

(#) DATA INDICATING THAT THE IMPLANTING DEPTH OF THE BORON CAN BE ESTIMATED BY A MEASUREMENT USING AN ELLIPSOMETRY

# FIG. 17

MIXED GAS PLASMA IRRADIATION
OF DIBORON AND HELIUM

TAKE A WAFER OUT

MEASURE A DEPTH OF AN AMORPHOUS LAYER
THROUGH AN ELLIPSOMETRY

WITHIN A
THRESHOLD
RANGE

GREATER THAN
THE THRESHOLD
RANGE

SMALLER THAN
THE THRESHOLD
RANGE

EXACTLY SET A
POWER TO BE
SUPPLIED TO A
SAMPLE
ELECTRODE

REDUCE THE
POWER TO BE
SUPPLIED TO THE
SAMPLE
ELECTRODE

INCREASE THE
POWER TO BE
SUPPLIED TO THE
SAMPLE
ELECTRODE

(#) A MECHANISM FOR OBTAINING A REPEATABILITY OF AN
IMPLANTING DEPTH OF BORON WITH HIGH PRECISION
THROUGH A MEASUREMENT USING AN ELLIPSOMETRY

# FIG. 18

# FIG. 19

# FIG. 20

*FIG. 21*

COMPARATIVE EXAMPLE
Average : 9.7nm
Repeatability : 1 $\sigma$ = 2.2 %

**INTERNATIONAL SEARCH REPORT**

| International application No. |
| --- |
| PCT/JP2006/306721 |

A. CLASSIFICATION OF SUBJECT MATTER
*H01121/265*(2006.01), *H01L21/22*(2006.01)

According to International Patent Classification (IPC) or to both national classification and IPC

B. FIELDS SEARCHED

Minimum documentation searched (classification system followed by classification symbols)
*H01121/265*(2006.01), *H01L21/22*(2006.01)

Documentation searched other than minimum documentation to the extent that such documents are included in the fields searched
Jitsuyo Shinan Koho     1922-1996    Jitsuyo Shinan Toroku Koho   1996-2006
Kokai Jitsuyo Shinan Koho    1971-2006    Toroku Jitsuyo Shinan Koho   1994-2006

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| Y | JP 2000-054150 A (Hitachi, Ltd.), 22 February, 2000 (22.02.00), Claims 1, 3, 5; Par. No. [0037] (Family: none) | 1-25 |
| Y | JP 11-330185 A (Matsushita Electronics Corp.), 30 November, 1999 (30.11.99), Claims 1, 2, 9 (Family: none) | 1-25 |
| Y | WO 1998/057146 A1 (Matsushita Electronics Corp.), 17 December, 1998 (17.12.98), Claim 4 & US 6128084 A | 1-25 |

☒ Further documents are listed in the continuation of Box C.     ☐ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 25 April, 2006 (25.04.06) | 16 May, 2006 (16.05.06) |

| Name and mailing address of the ISA/ Japanese Patent Office | Authorized officer |
| --- | --- |
| Facsimile No. | Telephone No. |

Form PCT/ISA/210 (second sheet) (April 2005)

**INTERNATIONAL SEARCH REPORT**

| International application No. |
|---|
| PCT/JP2006/306721 |

C (Continuation).   DOCUMENTS CONSIDERED TO BE RELEVANT

| Category* | Citation of document, with indication, where appropriate, of the relevant passages | Relevant to claim No. |
|---|---|---|
| Y | JP 2-068925 A  (Fuji Electric Co., Ltd.),<br>08 March, 1990 (08.03.90),<br>Page 2, upper left column, lines 3 to 8<br>(Family: none) | 1-25 |
| Y | JP 2004-179592 A  (Matsushita Electric<br>Industrial Co., Ltd.),<br>24 June, 2004 (24.06.04),<br>Full text<br>& WO 2004/051720 A1    & US 2005/0287776 A1<br>& TW 200415668 A | 1-25 |
| Y | JP 1-129413 A  (Kabushiki Kaisha Fuji Denki<br>Sogo Kenkyusho),<br>22 May, 1989 (22.05.89),<br>Full text<br>(Family: none) | 1-25 |
| Y | JP 2005-005328 A  (Matsushita Electric<br>Industrial Co., Ltd.),<br>06 January, 2005 (06.01.05),<br>Full text<br>& WO 2004/109785 A1 | 1-25 |

Form PCT/ISA/210 (continuation of second sheet) (April 2005)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **Y SASAKI et al.** B2H6 Plasma Doping with In-situ He Pre-amorphyzation. *2004 Symposia on VLSI Technology and Circuits*